(19) Europäisches Patentamt

European Patent Office

Office européen des brevets

(11) EP 1 357 434 A1

(12) EUROPEAN PATENT APPLICATION

(43) Date of publication:
29.10.2003 Bulletin 2003/44

(51) Int Cl.⁷: **G03F 7/20**, H02K 41/035, H02K 41/03

(21) Application number: 03252523.0

(22) Date of filing: 22.04.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: 23.04.2002 EP 02252853

(71) Applicant: ASML Netherlands B.V.
5503 LA Veldhoven (NL)

(72) Inventor: Roes, Franciscus Martines
5632 DZ Eindhoven (NL)

(74) Representative: Leeming, John Gerard
J.A. Kemp & Co.,
14 South Square,
Gray's Inn
London WC1R 5JJ (GB)

(54) **Lithographic apparatus and device manufacturing method**

(57) A means of providing pitch torque compensation for planar motors in which pitch torque is not inherently provided. The pitch torques for a given set of forces ideally required to be applied by each forcer in the planar motor may be calculated and summed. Correction forces for each forcer are determined such that the net effect of the corrections is equal and opposite to the pitch torques previously determined.

Fig. 7

**Description**

The present invention relates to a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- positioning one of the substrate and the patterning means with a planar motor; said planar motor comprised of a plurality of coil-sets, each producing at least one primary force in a given direction and at least one spurious torque, associated with the primary force, to the moving part of the planar motor; and
- determining the primary forces required to effect the positioning of the planar motor.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

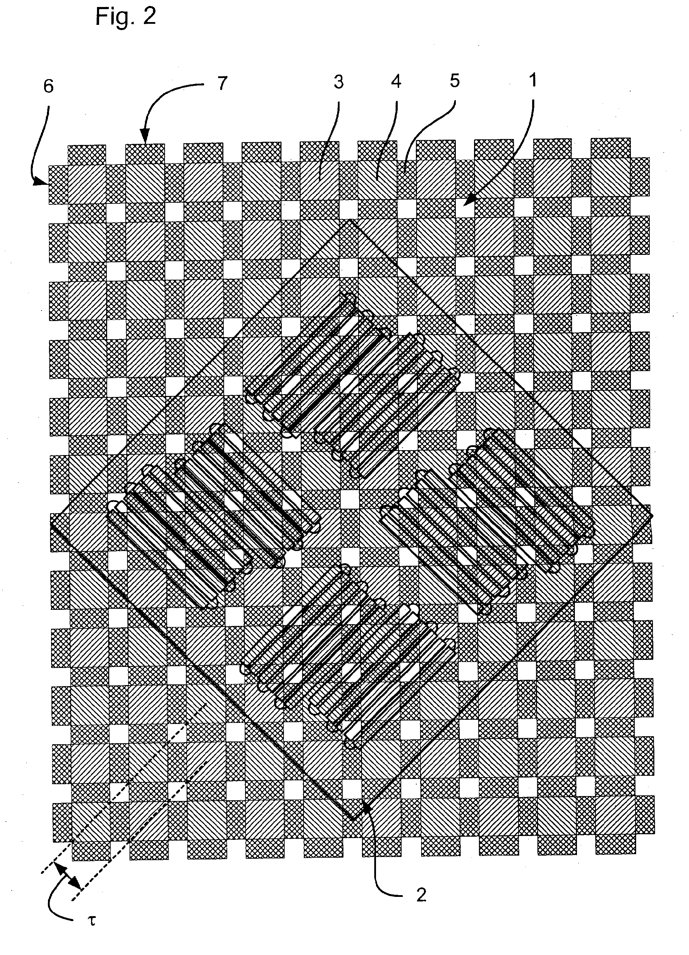

Figure 2 of the accompanying drawings shows a planar motor of a previously known design for positioning the patterning means and/or the substrate table. Further information on such planar motors may be found in WO 01/18944A, which is incorporated herein by reference. The planar motor as shown is comprised of a stationary part 1 and a movable part 2. The stationary part 1 is comprised of a plurality of permanent magnets 3, 4, 5, secured on a carrier. These magnets are arranged in rows 6 and columns 7.

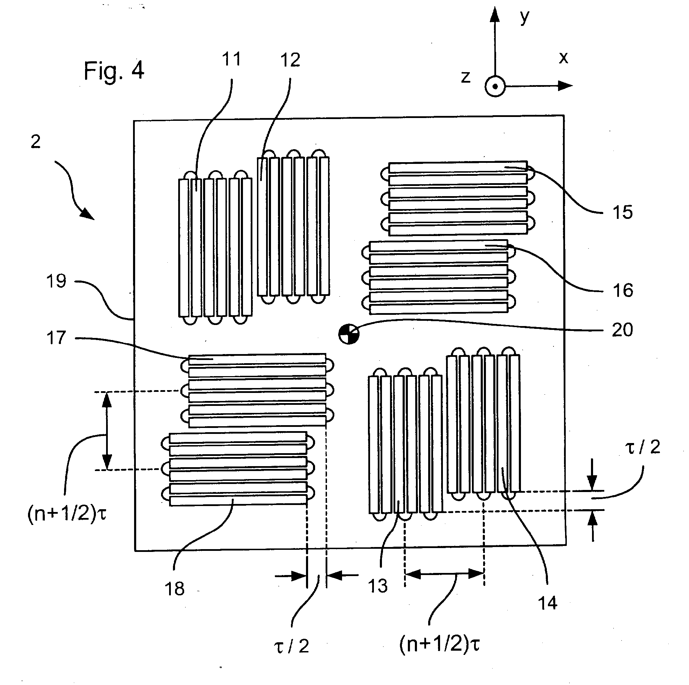

Figure 3 shows a detail of the stationary part 1 of the planar motor, showing the orientation of the magnets. The arrows indicate the direction of the magnetic polarization of the magnets. In each of the rows 6 and columns 7, adjacent primary magnets 3, 4 are orientated such that their magnetic polarization are anti-parallel to each other and perpendicular to the plane of the stationary part 1 of the planar motor. Between each of the primary magnets 3, 4 additional magnets 5 are arranged in a so-called Halbach configuration. That is to say, the additional magnets 5 are arranged such that their magnetic polarization is perpendicular to that of the primary magnets 3, 4.

Figure 4 shows in detail the moving part 2 of the presently known planar motor. For convenience, a set of orthogonal axis X, Y and Z are defined, as shown, such that the X and Y axis are in the plane of the planar motor and the Z axis is perpendicular to the plane of the planar motor. The centre of mass 20 of the moving part 2 of the planar motor may be used as the origin. The moving part 2 of the planar motor consists of 8 coil sets 11 to 18 mounted on a base 19. Each of the coil sets are provided with three phase currents which enable the coil sets, referred to as "forcers" to provide a force in the X or Y direction, depending on their orientation and a force in the Z direction. The forcers are arranged in pairs. As shown in Figure 4, forcers 11, 12 and 13, 14 are orientated such that their primary axis is in the Y direction. These forcers are therefore able to produce force in the X direction as well as the Z direction. The remaining forcers 15, 16 and 17, 18 are orientated such that their primary axis is in the X direction. These forcers provide forces in the Y direction as well as the Z direction. To produce a force on the moving part 2 in the X direction, the first pair of X-forcers 11, 12 and the second pair of X-forcers 13, 14 operate in unison. When the first pair of X-forcers 11, 12 and the second pair of X-forcers 13, 14 operate in opposite directions a torque about the Z axis is produced on the moving part 2 of the planar motor. Similarly, to produce a force on the moving part 2 of the planar motor in the Y direction, the first pair of Y-forcers 15, 16 and the second pair of Y-forcers 17, 18 operate in unison. When the first pair of Y-forcers 15, 16 operate opposed to the second pair of Y-forcers 17, 18, a torque about the Z axis is also produced. To produce a force in the Z direction, all of the forcers 11 to 18 produce their Z forces in unison. Torques about the X and Y axis may be produced by operating the first pair of Y-forcers 15, 16 to produce forces in the Z direction in unison with the first pair of X-forcers 11, 12 and opposed to the second pair of Y-forcers 17, 18 and the second pair of X-forcers 13, 14 or by operating the first pair of X-forcers in to produce forces in the Z direction in unison with the second pair of Y-forcers and opposed to the second pair of X-forcers and the first pair of Y-forcers, respectively.

By combining the forces produced in the manner described above, the position and velocity of the moving part 2 of the planar motor may be controlled in all six degrees of freedom (namely in each of the X, Y and Z directions and about axes parallel to each of the X, Y and Z directions). The Z-direction forces of the forcers 11 to 18 are used to bear the weight of the moving part 2 of the apparatus, thus obviating the requirement for a separate bearing. As shown in Figure 2, the planar motor operates with the X and Y axis of the moving part 2 at approximately 45° to the orientation of the rows 6 and columns 7 of the permanent magnets of the stationary part 1.

However, in addition to the forces in the Z direction and one of the X and Y direction, each of the forcers 11 to 18 also produces a spurious torque. The X-forcers produce a torque about the Y axis and the Y-forcers produce a torque about the X axis. The torque produced is a function of the force produced by the forcer in the Z direction, the force produced by the forcer in the X or Y direction and the position of a forcer in the X or Y direction. This spurious torque component is referred to as "pitch torque".

The X and Y forcers are provided in pairs in the presently known design of planar motors to counter the effect of the pitch torque. To affect this, each of the forcers in a pair is offset by an amount $\tau/2$. The positional offset is set to be one half of the pitch $\tau$ of the arrangement of the permanent magnets of the stationary part 1 of the planar motor (i. e. half of the distance between the diagonal lines of permanent magnets that are oriented in the same manner, as shown in Figure 2). Setting the positional offset to this distance $\tau/2$ results in the pitch torque produced by one forcer of a pair precisely offsetting the pitch torque produced by the other forcer of the pair. Therefore the net pitch torque within each pair is zero.

Providing the forcers in pairs is, however, disadvantageous. It doubles the number of forcers required, which increases the mass of the moving part of the planar motor and increases its size in the X-Y plane. This also increases the number of 3-phase amplifiers required (a 90 degrees phase shift is required between the 3-phase current system of forcer pairs so each pair of forcers requires two 3-phase amplifiers) as well as the complexity of the control system.

It is an object of the present invention to provide a device manufacturing method for use with a lithographic apparatus, such as that described above, in which compensation for pitch torque can be effected without the use of additional forcers and amplifiers.

This and other objects are achieved according to the invention in a device manufacturing method as specified in the opening paragraph, characterized by:

- determining a correction for each of the required primary forces such that the effect of the corrections at least partially compensates for the sum of the spurious torques on the moving part of the planar motor; and
- providing control signals to the coil-sets to effect the primary forces including the corrections.

This method represents an entirely different mechanism for dealing with pitch torques to the presently known techniques. It is advantageous in that it provides an opportunity to reduce the effect of pitch torque produced by the coil-sets in a planar motor without requiring additional, compensatory, coil-sets on the moving part of the planar motor. It can therefore be tuned by adjusting control parameters rather than by having to make physical alterations to the equipment.

In particular, the correction may be derived from the required primary forces rather than monitoring the difference between the required motion and the observed motion and deriving the correction from this motion. This significantly reduces the overall error in the motion.

The spurious torques that are compensated for in this method are, especially, those which are generated by each coil-set and act about an axis that is perpendicular to the direction of a primary force produced by the coil-set and parallel to the plane of the coils within the coil-set.

The step of determining the corrections may be performed by calculating the spurious torques that would be caused by the required primary forces being applied by the coil-sets without the corrections and then determining the combination of supplementary primary forces in the coil-sets that produces torques on the moving part of the planar motor that are equal an opposite to the sum of the spurious torques. These supplementary forces are then used as the corrections.

This procedure for compensating for pitch torques significantly reduces the effect of pitch torque using straight-forward control commands.

Alternatively, the step of determining the corrections may be performed by determining correction forces for each of the required primary forces such that, when the sum of the correction forces and the required primary forces are applied by the coil-sets, the sum of the effect of the primary forces and spurious torques substantially equals the forces and torques required to effect the positioning step.

This procedure for producing the offset is particularly beneficial since it substantially eliminates the effect of the spurious pitch torques.

According to a further aspect of the invention there is provided a computer program for controlling a lithographic projection apparatus, said computer program comprising code means for instructing the apparatus to perform the following steps:

- positioning one of the substrate and the patterning means with a planar motor; said planar motor comprised of a plurality of coil-sets, each producing at least one primary force in a given direction and at least one spurious torque, associated with the primary force, to the moving part of the planar motor; and
- determining the primary forces required to effect the positioning of the planar motor;

characterized in that said computer program further comprises code means for instructing the apparatus to perform the following steps:

- determining a correction for each of the required primary forces such that the effect of the corrections at least partially compensates for the sum of the spurious torques on the moving part of the planar motor; and
- providing control signals to the coil-sets to effect the primary forces including the corrections.

According to a further aspect of the invention there is provided a lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a planar motor for positioning one of the patterning means and the substrate table, said planar motor comprising a plurality of coil-sets, each producing at least one primary force in a given direction and at least one spurious torque, associated with the primary force, to the moving part of the planar motor; and
- means for determining the primary forces required to effect the positioning of the planar motor;

characterized in that said apparatus further comprises:

- means for determining a correction for each of the required primary forces such that the effect of the correction attenuates the sum of the spurious torques on the moving part of the planar motor; and
- a means of providing a control signal to each of the coil-sets to apply the sum of the required primary forces and the corrections at each coil-set.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 depicts a planar motor of a conventional design;
Figure 3 depicts a detail of the stationary part of a planar motor;
Figure 4 depicts the moving part of a planar motor of a conventional design;
Figure 5 depicts the moving part of a planar motor according to the present invention;
Figure 6 depicts an alternative of the moving part of a planar motor according to the present invention;
Figure 7 represents an element of the control system of a planar motor according to the present invention;
Figure 8 represents an alternative embodiment of an element of the control system of a planar motor according to the present invention;
Figure 9 represents further elements of the control system of a planar motor according to the present invention; and
Figure 10 shows an equation for use in compensating for the pitch torques.

In the Figures, corresponding reference symbols indicate corresponding parts.

Embodiment 1

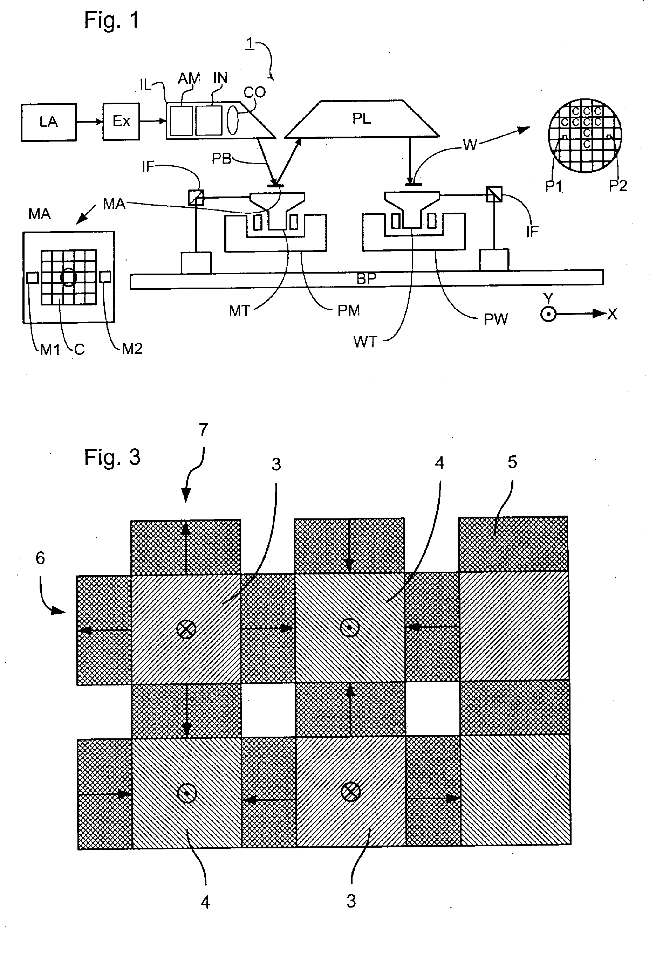

Figure 1 schematically depicts a lithographic projection apparatus according to a particular embodiment of the invention. The apparatus comprises:

a radiation system Ex, IL, for supplying a projection beam PB of radiation (e.g. EUV radiation), which in this particular case also comprises a radiation source LA;
a first object table (mask table) MT provided with a mask holder for holding a mask MA (e.g. a reticle), and connected to first positioning means for accurately positioning the mask with respect to item PL;
a second object table (substrate table) WT provided with a substrate holder for holding a substrate W (e.g. a resist-coated silicon wafer), and connected to second positioning means for accurately positioning the substrate with respect to item PL;
a projection system ("lens") PL (e.g. mirror group) for imaging an irradiated portion of the mask MA onto a target portion C (e.g. comprising one or more dies) of the substrate W.

As here depicted, the apparatus is of a reflective type (e.g. has a reflective mask). However, in general, it may also be of a transmissive type, for example (e.g. with a transmissive mask). Alternatively, the apparatus may employ another kind of patterning means, such as a programmable mirror array of a type as referred to above.

The source LA (e.g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

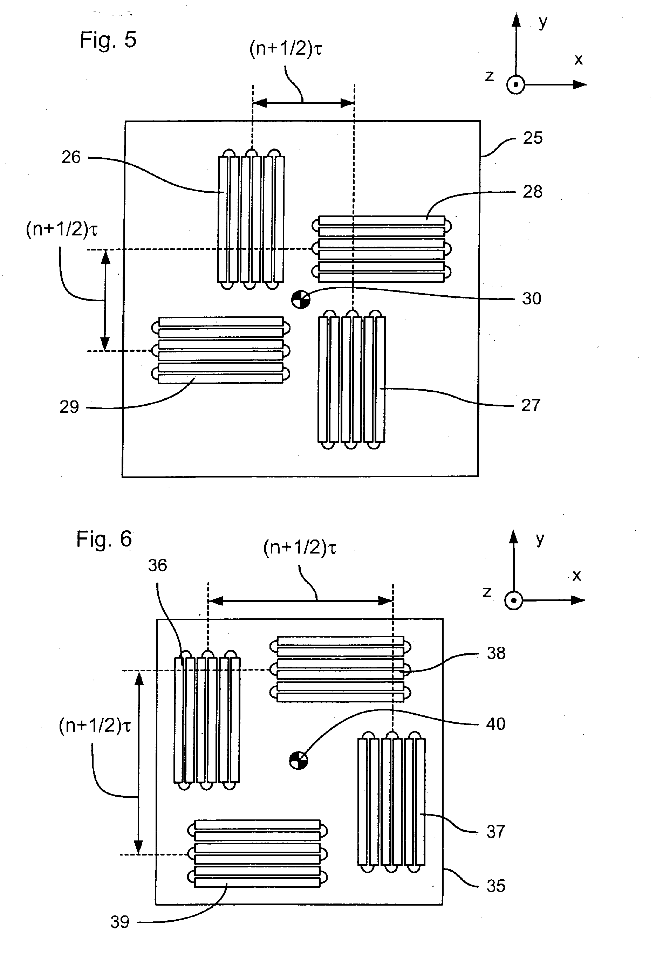

Figures 5 and 6 depict alternative arrangements for the moving part 25; 35 of a planar motor. The primary difference is that the forcers 26-28; 36-38 are not arranged in pairs as in the conventional design. In Figure 5, for example, there are two individual X-forcers 26, 27 which, operating in unison, produce forces in the X direction and, operating opposed to one another, produce torques around the Z axis. There are two Y-forcers 28, 29 which, when operating in unison, produce forces in the Y direction and, when operating opposed to one another, produce torques about the Z axis. When the first X-forcer 26 produces a force in the Z direction in unison with the first Y-forcer 29 and opposed to the second X-forcer 27 and the second Y-forcer 29, a torque about the X axis is produced. When the first X-forcer 26 produces a force in the Z direction in unison with the second Y-forcer 29 and opposite to the second X-forcer 27 and the first Y-forcer 28, a torque about the Y axis is produced. The control of the moving part 35 shown in Figure 6 is similar but the arrangement of the forcers 26-28 is consolidated.

However, since the forcers are not arranged in pairs, the pitch torque is not intrinsically compensated. The X-forcers generate a pitch torque Ty which is dependent on the force Fx produced by the forcer in the X direction, the force Fz produced in the Z direction and the position of the forcer in the X direction. Similarly the Y-forcers produce a pitch torque Tx which is dependent on the force Fy produced by the forcer in the Y direction, the force Fz produced by the forcer in the Z direction and the position of the forcer in the Y direction.

The pitch torques can be described by the following equations.

$$Ty_{x1} = C_1 \cdot Fx_{x1} \cdot \sin\left(\frac{2 \cdot \pi \cdot x}{\tau}\right) + C_2 \cdot Fz_{x1} \cdot \sin\left(\frac{2 \cdot \pi \cdot x}{\tau} + \frac{\pi}{2}\right) \qquad (1)$$

$$Ty_{x2} = -C_1 \cdot Fx_{x2} \cdot \sin\left(\frac{2 \cdot \pi \cdot x}{\tau}\right) - C_2 \cdot Fz_{x2} \cdot \sin\left(\frac{2 \cdot \pi \cdot x}{\tau} + \frac{\pi}{2}\right) \qquad (2)$$

$$Tx_{y1} = C_1 \cdot Fy_{y1} \cdot \sin\left(\frac{2 \cdot \pi \cdot y}{\tau}\right) + C_2 \cdot Fz_{y1} \cdot \sin\left(\frac{2 \cdot \pi \cdot y}{\tau} + \frac{\pi}{2}\right) \qquad (3)$$

$$Tx_{y2} = -C_1 \cdot Fy_{y2} \cdot \sin\left(\frac{2 \cdot \pi \cdot y}{\tau}\right) - C_2 \cdot Fz_{y2} \cdot \sin\left(\frac{2 \cdot \pi \cdot y}{\tau} + \frac{\pi}{2}\right) \qquad (4)$$

In which:

$Ty_{x\_}$ represents the y pitch torque caused by the first X-forcer 26, 36 and the second X-forcer 27; 37;
$Tx_{y\_}$ represents the x pitch torque caused by the first Y-force 28; 38 and the second Y-force 29; 39;
$Fx_{x\_}$ represents the x force generated by the first X-forcer 26; 36 and the second X-forcer 27;37;
$Fy_{y\_}$ represents the y force generated by the first Y-forcer 28; 38 and the second Y-forcer 29; 39;
$Fz\_$ represents for z force generated by the X- and Y-forcers 26-29; 36-39;
x represents the position, in the X direction, of the moving part of the planar motor relative to a predetermined position on the stationary part;
y represents the position, in the Y direction, of the moving part of the planar motor relative to a predetermined position on the stationary part;
C1 & C2 represent constants which are typical for the planar motor which are dependent, for example, on its geometry and the pitch of the magnets; and
τ represents the pitch of the magnets.

From these equations, the total pitch torque on the moving part 25; 35 of the planar motor can be calculated.

$$Ty_{tot} = C_1 \cdot \left(Fx_{x1} - Fx_{x2}\right) \cdot \sin\left(\frac{2 \cdot \pi \cdot x}{\tau}\right) + C_2 \cdot \left(Fz_{x1} - Fz_{x2}\right) \cdot \sin\left(\frac{2 \cdot \pi \cdot x}{\tau} + \frac{\pi}{2}\right) \quad (5)$$

$$Tx_{tot} = C_1 \cdot \left(Fy_{y1} - Fy_{y2}\right) \cdot \sin\left(\frac{2 \cdot \pi \cdot y}{\tau}\right) + C_2 \cdot \left(Fz_{y1} - Fz_{y2}\right) \cdot \sin\left(\frac{2 \cdot \pi \cdot y}{\tau} + \frac{\pi}{2}\right) \quad (6)$$

From the equations for the total pitch torques $Ty_{tot}, TX_{tot}$ (equations 5 and 6), it can be seen that when, as in the configurations shown in Figures 5 and 6, the X-forcers and Y-forcers, respectively, are arranged with a shift of $(n+1/2)\tau$, pitch torques are not produced when the force components in the X-forcers are the same and the force components in the Y-forcers are the same ($Fx_{x1} = Fx_{x2}$, $Fy_{y1} = Fy_{y2}$, $Fz_{x1} = Fz_{x2}$, and $Fz_{y1} = Fz_{y2}$). In other words, pitch torques are not generated when the X-forcers 26, 27 operate in unison and the Y-forcers 28, 29 operate in unison. This occurs when the overall required force on the moving part of the planar motor is a force in the X direction, a force in the Y direction, a force in the Z direction or some combination of these. However, pitch torques are generated when the force components in the X-forcers 26, 27 differ and/or similarly, when the force components in the Y-forcers 28, 29 differ. This occurs when torques about any of the X, Y and Z axis are required for the moving part 25 of the planar motor, for example during acceleration.

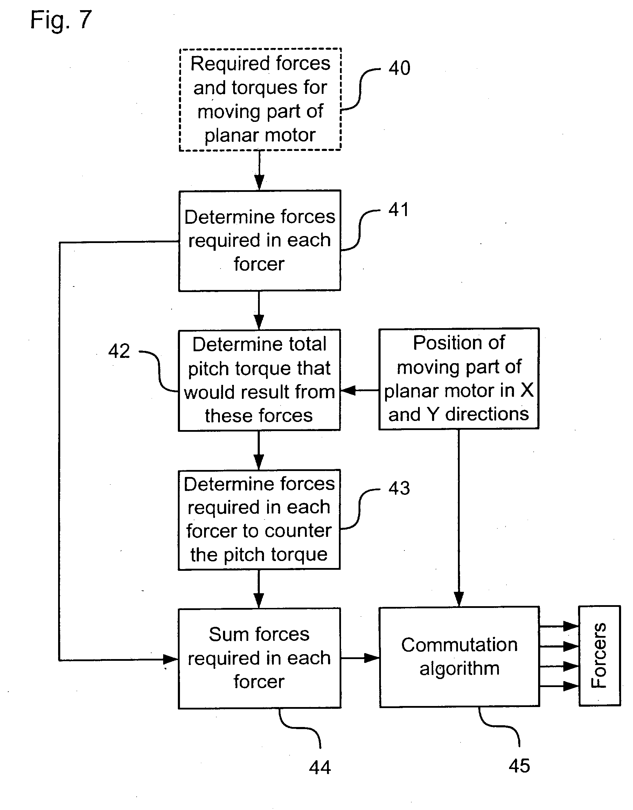

For a given combination of forces and torques that are required to be applied to the moving part 25 of the planar motor, equations 5 and 6 can be used to determine the pitch torque that will be produced. A compensatory torque can then be calculated and forces applied to each of the forces to produce this compensatory torque. This is summarized in Figure 7. The required forces and torques for the moving part of the planar motor are determined, and from these, in step 41, the forces required in each forcer are calculated. In step 42, the total pitch torque on the moving part of the planar motor engendered by producing by the forces in the forcers is calculated. Then, in step 43, the forces required in each forcer to offset the pitch torque are calculated. These offset forces are added, in step 44, to the forces that would have been required in each forcer without the pitch torque effect. A commutation algorithm is then applied in step 45 to determine the currents that need to be applied to each of the three phases of each of the four forcers to produce the required forces in each forcer.

Although the offset forces which are required to compensate for the pitch torque themselves produce further pitch torques, the amplitude is substantially lower than the initial pitch torque for the configurations shown in Figures 5 and 6. An iterative process may be used in which subsequent offset forces are determined to counteract the pitch torques produced by the previously determined offsets. The process can be repeated until the resultant pitch torques are below a given threshold value. One should note, however, that, as the moment arm between the point of effect of the first and second X-forcers and the first and second Y-forcers decreases, the benefit of this form of pitch torque compensation decreases.

Table 1 shows a comparison of the torques produced in a planar motor with the moving part 25 arranged as shown in Figure 5, with and without pitch torque compensation such as that described above. As shown, the compensation significantly reduces the error on the required torque.

Embodiment 2

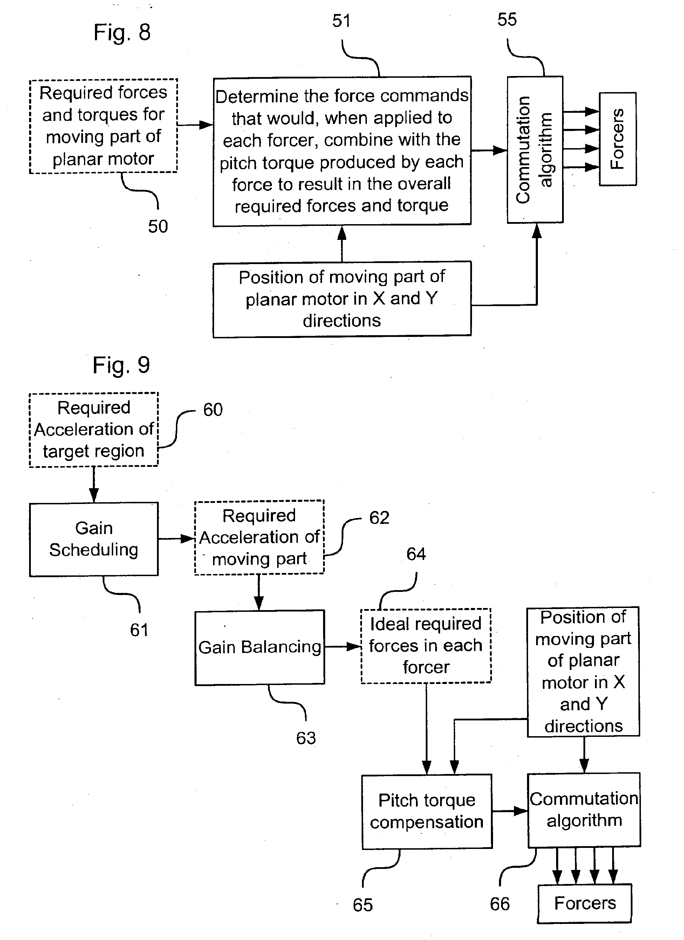

Figure 8 shows a scheme according to a second embodiment of the invention for compensating for the pitch torques produced in the forcers. In the first step 50, the required forces and torques for the moving part of the planar motor are determined. Then, in step 51, the control system determines the primary force commands that should be applied to the forcers such that, when the primary forces are combined with the parasitic pitch torques that are produced with the primary forces, the sum is equal to the required forces and torques in the moving part of the planar motor determined in step 50. The primary force commands are then applied to the commutation algorithm 55 which provides the required currents to the three phases of each of the four forcers.

In order to perform step 51, some mathematical modeling is required. The following equation models the moving part of the planar motor in the ideal situation, with no pitch torques. In order to provide a unique solution, the model requires that the force components in the Z-direction of the X-forcers provide half of the total force in the Z-direction and that the force components in the X-direction of the X-forcers provides half of the total torque about the Z-axis. This embodiment of the invention may also be implemented with other models, which use different assumptions, provided the determinant of the equivalent characteristic matrix shown in the equation below is non-zero.

$$\begin{bmatrix} Fx \\ Fy \\ Fz \\ Tx \\ Ty \\ Tz \\ 0.5 \cdot Fz \\ 0.5 \cdot Tz \end{bmatrix} = \begin{bmatrix} 1 & 1 & 0 & 0 & 0 & 0 & 0 & 0 \\ 0 & 0 & 1 & 1 & 0 & 0 & 0 & 0 \\ 0 & 0 & 0 & 0 & 1 & 1 & 1 & 1 \\ 0 & 0 & -z & -z & -y_{x1} & y_{x1} & y_{y1} & -y_{y1} \\ z & z & 0 & 0 & -x_{x1} & x_{x1} & -y_{y1} & y_{y1} \\ y_{x1} & -y_{x1} & x_{y1} & -x_{y1} & 0 & 0 & 0 & 0 \\ 0 & 0 & 0 & 0 & 1 & 1 & 0 & 0 \\ y_{x1} & -y_{x1} & 0 & 0 & 0 & 0 & 0 & 0 \end{bmatrix} \cdot \begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix} \qquad (7)$$

Fx, Fy and Fz are the total forces on the movable part of the planar motor, namely the required forces. Tx, Ty and Tz are the torques produced on the moving part of the planar motor about the respective axes, namely the required torques. As before, Fx_ represents the force produced by the denoted forcer (x1 or x2) in the X direction, Fy_ represents the force produced by the denoted forcer (yl or y2) in the Y direction and Fz_ represents the force produced by the denoted forcer (x1, x2, yl or y2) in the Z direction. The coordinates of the points of action of the forcers with respect to the center of mass 30; 40 of the moving part 25; 35 of the planar motor, are given by x, y or z with a subscript denoting the forcer ($x_1$, $x_2$, $y_1$ or $y_2$) In this model, it is assumed that the positions, in the Z-direction, of all the points of action of all of the forcers, relative to the center of mass 30; 40, are the same (z). It is also assumed that $x_{x1} = x_{x2}$, $y_{x1} = y_{x2}$, $x_{y1} = x_{y2}$ and $y_{y1} = y_{y2}$. Both these assumptions are not essential features of the present embodiment of the invention but are preferable as they reduce the complexity of the calculations.

When the pitch torques are introduced into the model, the equation becomes

$$\begin{bmatrix} Fx \\ Fy \\ Fz \\ Tx \\ Ty \\ Tz \\ 0.5 \cdot Fz \\ 0.5 \cdot Tz \end{bmatrix} = \begin{bmatrix} 1 & 1 & 0 & 0 & 0 & 0 & 0 & 0 \\ 0 & 0 & 1 & 1 & 0 & 0 & 0 & 0 \\ 0 & 0 & 0 & 0 & 1 & 1 & 1 & 1 \\ 0 & 0 & -z+\varphi & -z-\varphi & -y_{x1} & y_{x1} & y_{y1}+\theta & -y_{y1}-\theta \\ z+\alpha & z-\alpha & 0 & 0 & -x_{x1}+\beta & x_{x1}-\beta & -x_{y1} & x_{y1} \\ y_{x1} & -y_{x1} & x_{y1} & -x_{y1} & 0 & 0 & 0 & 0 \\ 0 & 0 & 0 & 0 & 1 & 1 & 0 & 0 \\ y_{x1} & -y_{x1} & 0 & 0 & 0 & 0 & 0 & 0 \end{bmatrix} \cdot \begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix} \quad (8)$$

where

$$\varphi = C_1 \cdot \sin\left(\frac{2 \cdot \pi \cdot y}{\tau}\right) \qquad (9)$$

$$\theta = C_2 \cdot \sin\left(\frac{2 \cdot \pi \cdot y}{\tau} + \frac{\pi}{2}\right) \qquad (10)$$

$$\alpha = C_1 \cdot \sin\left(\frac{2 \cdot \pi \cdot x}{\tau}\right) \qquad (11)$$

$$\beta = C_2 \cdot \sin\left(\frac{2 \cdot \pi \cdot x}{\tau} + \frac{\pi}{2}\right) \tag{12}$$

The pitch torque components $\varphi$, $\theta$, $\alpha$ and $\beta$ are the same as those discussed before with reference to the first embodiment.

This model allows us to determine the forces, $Fx_{x1}$ through $Fz_{y2}$, required in each forcer to produce the required forces and torques Fx through Tz on the moving part of the planar motor as a whole. By inverting the 8 by 8 matrix of Equation 8 we arrive at the following equation, from which the required primary forces for each forcer can be determined from the overall forces and torques required for the moving part of the planar motor.

$$
\begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix} = \frac{1}{2} \cdot
\begin{bmatrix}
1 & 0 & 0 & 0 & 0 & 0 & 0 & \dfrac{1}{y_{x1}} \\[2mm]
1 & 0 & 0 & 0 & 0 & 0 & 0 & -\dfrac{1}{y_{x1}} \\[2mm]
0 & 1 & 0 & 0 & 0 & \dfrac{1}{x_{y1}} & 0 & -\dfrac{1}{x_{y1}} \\[2mm]
0 & 1 & 0 & 0 & 0 & -\dfrac{1}{x_{y1}} & 0 & \dfrac{1}{x_{y1}} \\[2mm]
z\cdot\dfrac{y_{y1}+\theta}{D} & -z\cdot\dfrac{x_{y1}}{D} & 0 & -\dfrac{x_{y1}}{D} & -\dfrac{y_{y1}+\theta}{D} & \dfrac{\varphi}{D} & 1 & \dfrac{\left(-y_{x1}\cdot\varphi+y_{y1}\cdot\alpha+\theta\cdot\alpha\right)}{y_{x1}\cdot D} \\[3mm]
-z\cdot\dfrac{y_{y1}+\theta}{D} & z\cdot\dfrac{x_{y1}}{D} & 0 & \dfrac{x_{y1}}{D} & \dfrac{y_{y1}+\theta}{D} & -\dfrac{\varphi}{D} & 1 & -\dfrac{\left(-y_{x1}\cdot\varphi+y_{y1}\cdot\alpha+\theta\cdot\alpha\right)}{y_{x1}\cdot D} \\[3mm]
z\cdot\dfrac{y_{x1}}{D} & z\cdot\dfrac{(x_{x1}-\beta)}{D} & 1 & \dfrac{(x_{x1}-\beta)}{D} & -\dfrac{y_{x1}}{D} & -\varphi\cdot\dfrac{(x_{x1}-\beta)}{(x_{y1}\cdot D)} & -1 & \dfrac{\left(\alpha\cdot x_{y1}+\varphi\cdot x_{x1}-\varphi\cdot\beta\right)}{x_{y1}\cdot D} \\[3mm]
-z\cdot\dfrac{y_{x1}}{D} & -z\cdot\dfrac{(x_{x1}-\beta)}{D} & 1 & -\dfrac{(x_{x1}-\beta)}{D} & \dfrac{y_{x1}}{D} & \varphi\cdot\dfrac{(x_{x1}-\beta)}{(x_{y1}\cdot D)} & -1 & -\dfrac{\left(\alpha\cdot x_{y1}+\varphi\cdot x_{x1}-\varphi\cdot\beta\right)}{x_{y1}\cdot D}
\end{bmatrix}
\cdot
\begin{bmatrix} Fx \\ Fy \\ Fz \\ Tx \\ Ty \\ Tz \\ 0.5\cdot Fz \\ 0.5\cdot Tz \end{bmatrix}
$$

$$(13)$$

In which

$$D = \left(y_{x1}\cdot x_{y1} - \beta\cdot\theta + x_{x1}\cdot y_{y1} + x_{x1}\cdot\theta - \beta\cdot y_{y3}\right) \tag{14}$$

The number of calculations required to determine the forces required in each of the forcers may be reduced by spotting that many of the terms in the computation for each of the X and Y forcers is simply the negative of the term for the other of the X or Y forcers. $\varphi$, $\theta$, $\alpha$ and $\beta$ (and therefore D) are all dependent on the position of the moving part of the planar motor and therefore must be updated as the motor operates.

All of the calculations to find the required forces in each of the forcers may be performed each time the force calculations are updated. Alternatively some of the calculations, such as the values of $\varphi$, $\theta$, $\alpha$ and $\beta$ (in which the only variable is the position of the moving part of the planar motor relative to the stationary part) may be pre-calculated for a range of positions and stored in a memory. The remaining calculations are performed using the appropriate value from a memory. The range of positions for which values would be required would simply be the range of the centroid of the moving part of the planar motor relative to one of the magnets in the stationary part. Other positions of the moving part of the planar motor have the same values of $\varphi$, $\theta$, $\alpha$ and $\beta$ when the centroid is in the same relative position to another magnet in the stationary part that is oriented with is magnetic polarization parallel to that of the first magnet.

Embodiment 3

A third way to compensate for the pitch torques produced by the forces is to provide a learning algorithm, such as a neural network, that can be trained to provide the right forces commands for each of the forces (or, directly, the requisite three phase currents for each forcer) to produce the overall required force and torques on the moving part of the planar motor.

In all of the above embodiments, the pitch torque compensation is only a part of the control system required to control the moving part of the planar motor. Figure 9 depicts further components in the control system. In step 60, the required accelerations (both straight line and rotational) of a target region on the mask or substrate, mounted on the moving part of the planar motor are determined. A process 61, referred to as "gain scheduling", is performed to determine the required acceleration 62 of the moving part of the planar motor in order to produce the required acceleration of the target region. Subsequently, a process 63, referred to as "gain balancing" is used to determined the required forces and torques 64 for the moving part of the planar motor.

This process 63 takes into account the forces, other than those produced by the forcers, on the middle part of the planar motor. These forces may, for example, include the weight of the moving part of the planar motor, and external forces such as the cable arm. The gain balancing may also take into account the position of the point of action of each force produced by the forcers. The product of the gain balancing process 63 in this case is the ideal required force 64 for each forcer. However, this does not take account of the pitch torque. Therefore, in step 65, the pitch torque is compensated for. The real forces required in each forcer is then provided to the communication algorithm 66 which determines the required currents for each of the three phases for each of the four forces. Further information on gain scheduling may be found in European application No.02250966.5, which is incorporated herein by reference.

The pitch torque compensation may be provided by any of the methods described above. For example, in the first embodiment steps 42 to 44, as shown in Figure 7, may be used. In the second embodiment, Equation 13 already takes into account the position of the point of action of the forcers. The gain balancing therefore need only take account of the other forces acting on the moving part of the planar motor and determine the required overall forces and torques for the moving part as a whole. Alternatively, it may be desirable to perform standard gain balancing, the product of which is the required forces in each forcer, and from this determine the required force commands that should be provided to the forcers to compensate for the pitch torques. To effect this by the method of the second embodiment, some further processing is required. For simplicity, Equation 7 above may be rewritten as:

$$
\begin{bmatrix}
Fx \\
Fy \\
Fz \\
Tx \\
Ty \\
Tz \\
0.5 \cdot Fz \\
0.5 \cdot Tz
\end{bmatrix}
= \begin{bmatrix} A_{ideal} \end{bmatrix} \cdot \begin{bmatrix} F_{ideal} \end{bmatrix}
\tag{15}
$$

in which $[A_{ideal}]$ is the 8 x 8 matrix modelling the ideal relationship (i.e. not incorporating pitch torque) between the overall forces and torques on the moving part of the planar motor and the forces in each of the forces. Similarly Equation 8 above can be rewritten as

$$\begin{bmatrix} Fx \\ Fy \\ Fz \\ Tx \\ Ty \\ Tz \\ 0.5 \cdot Fz \\ 0.5 \cdot Tz \end{bmatrix} = \begin{bmatrix} A_{real} \end{bmatrix} \cdot \begin{bmatrix} F_{real} \end{bmatrix} \tag{16}$$

in which $[A_{real}]$ is the 8 x 8 matrix incorporating the pitch torques into the model. Combining these two equations and rearranging, the following equation is produced

$$\begin{bmatrix} F_{real} \end{bmatrix} = \begin{bmatrix} A_{real} \end{bmatrix}^{-1} \begin{bmatrix} A_{ideal} \end{bmatrix} \begin{bmatrix} F_{ideal} \end{bmatrix} \tag{17}$$

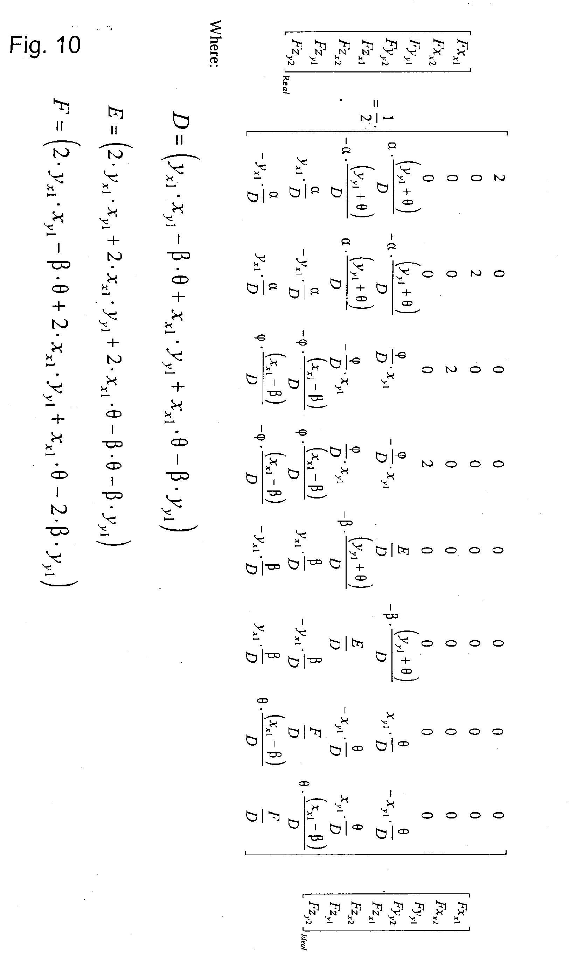

We therefore have a relationship between the real forces $[F_{real}]$ that must be provided to the forcers, taking account of the pitch torques, and the ideal forces $[F_{ideal}]$ that are determined in the gain balancing step 63. For convenience, the expanded version of equation 17 is shown as Figure 10 on the accompanying drawings. Again, the amount of computation required is reduced by the fact that many of the terms for each of the forces required in the X and Y forcers are the negative of the terms required for the other of the X and Y forcers. As before, $\varphi$, $\theta$, $\alpha$ and $\beta$ (and hence D) are dependent on the position of the moving part of the planar motor and therefore need to be updated as the motor operates.

Whilst specific embodiments of the invention have been described above, it will be appreciated that the invention may be practiced otherwise than as described. The description is not intended to limit the invention.

| Table 1. Deviations of the desired torque with and without compensation. | | | | |
|---|---|---|---|---|
| | Uncompensated max/min | | Compensated max/min | |
| T desired | Tx, actual [Nm] | Ty, actual [Nm] | Tx, actual [Nm] | Ty, actual Nm] |
| Tx = 1 Nm | 1.03/0.97 | 0.066/-0.066 | +1.003/+0.995 | +5e-4/-4e-3 |
| Ty = 1 Nm | 0.066/-0.066 | 1.03/0.97 | +4e-3/-5e-4 | +1.003/+0.995 |
| Tz = 1 Nm | +4e-2/-4e-2 | +4e-2/-4e-2 | +3e-3/-3e-3 | +3e-3/-3e-3 |
| Tx = Ty = Yz = 1 Nm | 1.054/0.946 | 1.104/0.896 | 1.008/0.994 | 1.002/0.993 |

## Claims

1. A device manufacturing method comprising the steps of:

   - providing a substrate that is at least partially covered by a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material,
   - positioning one of the substrate and the patterning means with a planar motor; said planar motor comprised of a plurality of coil-sets, each producing at least one primary force in a given direction and at least one spurious torque, associated with the primary force, to the moving part of the planar motor; and
   - determining the primary forces required to effect the positioning of the planar motor;

   **characterised by**

- determining a correction for each of the required primary forces such that the effect of the corrections at least partially compensates for the sum of the spurious torques on the moving part of the planar motor; and
- providing control signals to the coil-sets to effect the primary forces including the corrections.

2. A device manufacturing method as claim 1, wherein the correction is derived from the required primary forces.

3. A device manufacturing method as claim 1 or 2, wherein the spurious torque generated by each coil set acts about an axis that is perpendicular to the direction of said at least one primary force produced by the coil-set and parallel to the plane of the coils within the coil-set.

4. A device manufacturing method as any one of claims 1 to 3, wherein said step of determining the corrections comprises:

   - determining the spurious torques that would be caused by the required primary forces being applied by the coil-sets without the corrections;
   - determining the combination of supplementary primary forces in the coil-sets that produces torques on the moving part of the planar motor that are equal an opposite to the sum of the spurious torques; and
   - using these supplementary forces as the corrections.

5. A device manufacturing method as any one of claims 1 to 3, wherein said step of determining the corrections comprises:

   - determining correction forces for each said required primary force such that, when the sum of the correction forces and the required primary forces are applied by the coil-sets, the sum of the effect of the primary forces and spurious torques is substantially the forces and torques required to effect the positioning step.

6. A device manufacturing method as claim 5, wherein the step determining the required sum of the offset forces and the required primary forces is performed using the following equation:

$$
\begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix} = \frac{1}{2} \cdot
\begin{bmatrix}
1 & 0 & 0 & 0 & 0 & 0 & 0 & \frac{1}{y_{x1}} \\
1 & 0 & 0 & 0 & 0 & 0 & 0 & -\frac{1}{y_{x1}} \\
0 & 1 & 0 & 0 & 0 & \frac{1}{x_{y1}} & 0 & -\frac{1}{x_{y1}} \\
0 & 1 & 0 & 0 & 0 & -\frac{1}{x_{y1}} & 0 & \frac{1}{x_{y1}} \\
z \cdot \frac{y_{y1}+\theta}{D} & -z \cdot \frac{x_{y1}}{D} & 0 & -\frac{x_{y1}}{D} & -\frac{y_{y1}+\theta}{D} & \frac{\varphi}{D} & 1 & \frac{(-y_{x1}\cdot\varphi + y_{y1}\cdot\alpha + \theta\cdot\alpha)}{y_{x1}\cdot D} \\
-z \cdot \frac{y_{y1}+\theta}{D} & z \cdot \frac{x_{y1}}{D} & 0 & \frac{x_{y1}}{D} & \frac{y_{y1}+\theta}{D} & -\frac{\varphi}{D} & 1 & -\frac{(-y_{x1}\cdot\varphi + y_{y1}\cdot\alpha + \theta\cdot\alpha)}{y_{x1}\cdot D} \\
z \cdot \frac{y_{x1}}{D} & z \cdot \frac{(x_{x1}-\beta)}{D} & 1 & \frac{(x_{x1}-\beta)}{D} & -\frac{y_{x1}}{D} & -\varphi \cdot \frac{(x_{x1}-\beta)}{(x_{y1}\cdot D)} & -1 & \frac{(\alpha\cdot x_{y1} + \varphi\cdot x_{x1} - \varphi\cdot\beta)}{x_{y1}\cdot D} \\
-z \cdot \frac{y_{x1}}{D} & -z \cdot \frac{(x_{x1}-\beta)}{D} & 1 & -\frac{(x_{x1}-\beta)}{D} & \frac{y_{x1}}{D} & \varphi \cdot \frac{(x_{x1}-\beta)}{(x_{y1}\cdot D)} & -1 & -\frac{(\alpha\cdot x_{y1} + \varphi\cdot x_{x1} - \varphi\cdot\beta)}{x_{y1}\cdot D}
\end{bmatrix}
\cdot
\begin{bmatrix} Fx \\ Fy \\ Fz \\ Tx \\ Ty \\ Tz \\ 0.5\cdot Fz \\ 0.5\cdot Tz \end{bmatrix}
$$

in which:

$$ \varphi = C_1 \cdot \sin\left( \frac{2\cdot\pi\cdot y}{\tau} \right) $$

$$\theta = C_2 \cdot \sin\left(\frac{2 \cdot \pi \cdot y}{\tau} + \frac{\pi}{2}\right)$$

$$\alpha = C_1 \cdot \sin\left(\frac{2 \cdot \pi \cdot x}{\tau}\right)$$

$$\beta = C_2 \cdot \sin\left(\frac{2 \cdot \pi \cdot x}{\tau} + \frac{\pi}{2}\right)$$

$$D = \left(y_{x1} \cdot x_{y1} - \beta \cdot \theta + x_{x1} \cdot y_{y1} + x_{x1} \cdot \theta - \beta \cdot y_{y3}\right)$$

where:

$Fx_{x\_}$ represents the force generated in a first direction, designated X, by a first X-forcer x1 and a second X-forcer x2;

$Fy_{y\_}$ represents the force generated in a second direction, perpendicular to the first direction and designated Y, by a first Y-forcer y1 and a second Y-forcer y2;

$Fz\_$ represents a force generated in a third direction, perpendicular to the first and second directions and designated Z, by the X- and Y-forcers x1, x2, y1 and y2;

C1 and C2 are constants for the specific planar motor;

x represents the position, in the X direction, of the moving part of the planar motor relative to a predetermined position on the stationary part;

y represents the position, in the Y direction, of the moving part of the planar motor relative to a predetermined position on the stationary part;

$\tau$ represents the pitch of the arrangement of permanent magnets used in the stationary part of the planar motor;

$X_{x1}$ represents the distance in the X direction between the point of action of the first X-forcer x1 and the center of mass of the moving part of the planar motor and between the point of action of the second X-forcer x2 and the center of mass of the moving part of the planar motor;

$x_{y1}$ represents the distance in the X direction between the point of action of the first Y-forcer y1 and the center of mass of the moving part of the planar motor and

between the point of action of the second Y-forcer y2 and the center of mass of the moving part of the planar motor;

$y_{x1}$ represents the distance in the Y direction between the point of action of the first X-forcer x1 and the center of mass of the moving part of the planar motor and between the point of action of the second X-forcer x2 and the center of mass of the moving part of the planar motor;

$y_{y1}$ represents the distance in the Y direction between the point of action of the first Y-forcer y1 and the center of mass of the moving part of the planar motor and between the point of action of the second Y-forcer y2 and the center of mass of the moving part of the planar motor;

z represents the distance in the Z direction between the point of action of all of the forcers and the center of mass of the moving part of the planar motor;

Fx represents the. force on the moving part of the planar motor required in the X direction to position the moving part of the planar motor;

Fy represents the force on the moving part of the planar motor required in the Y direction to position the moving part of the planar motor;

Fz represents the force on the moving part of the planar motor required in the Z direction to position the moving part of the planar motor;

Tx represents the torque on the moving part of the planar motor required about an axis parallel to the X direction to position the moving part of the planar motor;

Ty represents the torque on the moving part of the planar motor required about an axis parallel to the Y direction to position the moving part of the planar motor; and

Tz represents the torque on the moving part of the planar motor required about an axis parallel to the Z direction to position the moving part of the planar motor.

**7.** A device manufacturing method according to any preceding claim, wherein, in said positioning step, only four coil-sets are used to provide the positioning force; and said four coil-sets produce forces in two orthogonal directions parallel to the plane of the coil-sets.

**8.** A computer program for controlling a lithographic projection apparatus, said computer program comprising code means for instructing the apparatus to perform the following steps:

- positioning one of the substrate and the patterning means with a planar motor; said planar motor comprised of a plurality of coil-sets, each producing at least one primary force in a given direction and at least one spurious torque, associated with the primary force, to the moving part of the planar motor; and
- determining the primary forces required to effect the positioning of the planar motor;

**characterized in that** said computer program further comprises code means for instructing the apparatus to perform the following steps:

- determining a correction for each of the required primary forces such that the effect of the corrections at least partially compensates for the sum of the spurious torques on the moving part of the planar motor; and
- providing control signals to the coil-sets to effect the primary forces including the corrections.

**9.** A lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a planar motor for positioning one of the patterning means and the substrate table, said planar motor, comprising a plurality of coil-sets, each producing at least one primary force in a given direction and at least one spurious torque, associated with the primary force, to the moving part of the planar motor; and
- means for determining the primary forces required to effect the positioning of the planar motor;

**characterised in that** said apparatus further comprises:

- means for determining a correction for each of the required primary forces such that the effect of the correction attenuates the sum of the spurious torques on the moving part of the planar motor; and
- a means of providing a control signal to each of the coil-sets to apply the sum of the required primary forces and the corrections at each coil-set.

Fig. 1

Fig. 3

Fig. 2

Fig. 4

Fig. 5

(n+1/2)τ

26

28

(n+1/2)τ

30

29

27

y

x

z

Fig. 6

36

(n+1/2)τ

38

40

(n+1/2)τ

37

39

35

y

x

z

Fig. 7

```
┌ ─ ─ ─ ─ ─ ─ ─ ─ ┐
   Required forces        40
   and torques for
   moving part of
   planar motor
└ ─ ─ ─ ─ ─ ─ ─ ─ ┘
        │
        ▼
┌─────────────────┐
│ Determine forces │   41
│ required in each │
│     forcer       │
└─────────────────┘
        │
        ▼
┌─────────────────┐        ┌─────────────────┐
│ Determine total │        │   Position of    │
│ pitch torque that│  42   │  moving part of  │
│ would result from│◄──────│ planar motor in X│
│   these forces   │        │  and Y directions│
└─────────────────┘        └─────────────────┘
        │
        ▼
┌─────────────────┐
│ Determine forces │   43
│ required in each │
│ forcer to counter│
│  the pitch torque│
└─────────────────┘
        │
        ▼
┌─────────────────┐        ┌─────────────────┐        ┌────────┐
│   Sum forces    │        │  Commutation    │───────►│ Forcers│
│ required in each │───────►│   algorithm     │        │        │
│     forcer      │        │                 │        │        │
└─────────────────┘        └─────────────────┘        └────────┘
        44                          45
```

## Fig. 8

```
┌─────────────────┐      ┌──────────────────────────┐   ┌──────────┐   ┌────────┐
│ Required forces │      │ Determine the force      │   │          │   │        │
│ and torques for │──────▶│ commands that would,     │──▶│Commutation│──▶│ Forcers│
│ moving part of  │      │ when applied to each     │   │ algorithm│   │        │
│ planar motor    │      │ forcer, combine with the │   │          │   │        │
└─────────────────┘      │ pitch torque produced by │   └──────────┘   └────────┘
                         │ each force to result in  │        ▲
                         │ the overall required     │        │
                         │ forces and torque        │        │
                         └──────────────────────────┘        │
                                    ▲                         │
                                    │                         │
                    ┌─────────────────────────────┐          │
                    │ Position of moving part of  │          │
                    │ planar motor in X and Y     │──────────┘
                    │ directions                  │
                    └─────────────────────────────┘
```

50, 51, 55

## Fig. 9

```
┌──────────────┐
│ Required     │ 60
│ Acceleration │
│ of target    │
│ region       │
└──────────────┘
       │
       ▼
┌──────────────┐   ┌──────────────┐
│ Gain         │   │ Required     │ 62
│ Scheduling   │──▶│ Acceleration │
│              │   │ of moving    │
└──────────────┘   │ part         │
      61           └──────────────┘
                          │
                          ▼
                   ┌──────────────┐   ┌──────────────┐   ┌──────────────┐
                   │ Gain         │   │ Ideal        │64 │ Position of  │
                   │ Balancing    │──▶│ required     │   │ moving part  │
                   │              │   │ forces in    │   │ of planar    │
                   └──────────────┘   │ each forcer  │   │ motor in X   │
                        63            └──────────────┘   │ and Y        │
                                             │           │ directions   │
                                             │           └──────────────┘
                                             ▼                  │
                                      ┌──────────────┐   ┌──────────────┐
                                      │ Pitch torque │   │ Commutation  │
                                      │ compensation │──▶│ algorithm    │
                                      └──────────────┘   └──────────────┘
                                            65                 66 │
                                                                  ▼
                                                           ┌──────────────┐
                                                           │   Forcers    │
                                                           └──────────────┘
```

$$
\begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix}_{Real} = \frac{1}{2} \cdot \begin{bmatrix}
2 & 0 & 0 & 0 & 0 & 0 & 0 & 0 \\
0 & 2 & 0 & 0 & 0 & 0 & 0 & 0 \\
0 & 0 & 2 & 0 & 0 & 0 & 0 & 0 \\
0 & 0 & 0 & 2 & 0 & 0 & 0 & 0 \\
\alpha \cdot \dfrac{(y_{y1}+\theta)}{D} & -\alpha \cdot \dfrac{(y_{y1}+\theta)}{D} & \dfrac{\varphi}{D} \cdot x_{y1} & -\dfrac{\varphi}{D} \cdot x_{y1} & \dfrac{E}{D} & -\beta \cdot \dfrac{(y_{y1}+\theta)}{D} & x_{y1} \cdot \dfrac{\theta}{D} & -x_{y1} \cdot \dfrac{\theta}{D} \\
-\alpha \cdot \dfrac{(y_{y1}+\theta)}{D} & \alpha \cdot \dfrac{(y_{y1}+\theta)}{D} & -\dfrac{\varphi}{D} \cdot x_{y1} & \dfrac{\varphi}{D} \cdot x_{y1} & -\beta \cdot \dfrac{(y_{y1}+\theta)}{D} & \dfrac{E}{D} & -x_{y1} \cdot \dfrac{\theta}{D} & x_{y1} \cdot \dfrac{\theta}{D} \\
y_{x1} \cdot \dfrac{\alpha}{D} & -y_{x1} \cdot \dfrac{\alpha}{D} & -\varphi \cdot \dfrac{(x_{x1}-\beta)}{D} & \varphi \cdot \dfrac{(x_{x1}-\beta)}{D} & y_{x1} \cdot \dfrac{\beta}{D} & -y_{x1} \cdot \dfrac{\beta}{D} & \dfrac{F}{D} & \theta \cdot \dfrac{(x_{x1}-\beta)}{D} \\
-y_{x1} \cdot \dfrac{\alpha}{D} & y_{x1} \cdot \dfrac{\alpha}{D} & \varphi \cdot \dfrac{(x_{x1}-\beta)}{D} & -\varphi \cdot \dfrac{(x_{x1}-\beta)}{D} & -y_{x1} \cdot \dfrac{\beta}{D} & y_{x1} \cdot \dfrac{\beta}{D} & \theta \cdot \dfrac{(x_{x1}-\beta)}{D} & \dfrac{F}{D}
\end{bmatrix} \cdot \begin{bmatrix} Fx_{x1} \\ Fx_{x2} \\ Fy_{y1} \\ Fy_{y2} \\ Fz_{x1} \\ Fz_{x2} \\ Fz_{y1} \\ Fz_{y2} \end{bmatrix}_{Ideal}
$$

Where:

$$
D = \left( y_{x1} \cdot x_{y1} - \beta \cdot \theta + x_{x1} \cdot y_{y1} + x_{x1} \cdot \theta - \beta \cdot y_{y1} \right)
$$

$$
E = \left( 2 \cdot y_{x1} \cdot x_{y1} + 2 \cdot x_{x1} \cdot y_{y1} + 2 \cdot x_{x1} \cdot \theta - \beta \cdot \theta - \beta \cdot y_{y1} \right)
$$

$$
F = \left( 2 \cdot y_{x1} \cdot x_{y1} - \beta \cdot \theta + 2 \cdot x_{x1} \cdot y_{y1} + x_{x1} \cdot \theta - 2 \cdot \beta \cdot y_{y1} \right)
$$

Fig. 10

22

**European Patent Office**

**EUROPEAN SEARCH REPORT**

Application Number

EP 03 25 2523

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 196 745 A (TRUMPER DAVID L) 23 March 1993 (1993-03-23) * abstract * * column 1, line 10 - line 28 * * column 5, line 21 - column 6, line 14 * * column 9, line 25 - line 64; figure 7 * --- | 1-9 | G03F7/20 H02K41/035 H02K41/03 |
| X | US 6 144 118 A (CAHILL STEVEN P ET AL) 7 November 2000 (2000-11-07) * abstract; figures 1,2 * * column 3, line 60 - line 67 * * column 6, line 18 - line 52 * * column 10, line 7 - line 11 * * claim 43 * --- | 1-9 | |
| A | EP 0 502 578 A (PHILIPS NV) 9 September 1992 (1992-09-09) * column 16, line 53 - column 17, line 9 * --- | 1-9 | |
| A | EP 1 001 512 A (ASM LITHOGRAPHY BV) 17 May 2000 (2000-05-17) * paragraphs [0001]-[0003],[0018],[0027]-[0029],[0039]; claim 12 * --- | 1-9 | TECHNICAL FIELDS SEARCHED (Int.Cl.7) G03F H02K |
| A | US 6 028 376 A (AKUTSU KOTARO ET AL) 22 February 2000 (2000-02-22) * column 6, line 32 - line 47 * * column 10, line 40 - line 65 * * column 11, line 1 - column 12, line 13 * --- | 1-9 | |
| A | US 6 147 421 A (HAZELTON ANDREW J ET AL) 14 November 2000 (2000-11-14) * the whole document * --- | 1-9 | |
| A | US 6 208 045 B1 (BINNARD MICHAEL B ET AL) 27 March 2001 (2001-03-27) * the whole document * --- | 1-9 | |

-/--

The present search report has been drawn up for all claims

| Place of search | Date of completion of the search | Examiner |
|---|---|---|
| MUNICH | 20 August 2003 | van Toledo, W |

## EUROPEAN SEARCH REPORT

**European Patent Office**

**Application Number**

EP 03 25 2523

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2002/000904 A1 (COMPTER JOHAN CORNELIS ET AL) 3 January 2002 (2002-01-03) * paragraphs [0002],[0003],[0009],[0024],[0030] * --- | 1-9 | |
| A | DE 31 23 759 A (JENOPTIK JENA GMBH) 15 July 1982 (1982-07-15) * page 7 - page 8 * ----- | 1-9 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 20 August 2003 | van Toledo, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EP 1 357 434 A1

## ANNEX TO THE EUROPEAN SEARCH REPORT
## ON EUROPEAN PATENT APPLICATION NO.

EP 03 25 2523

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2003

| Patent document cited in search report | | Publication date | Patent family member(s) | | Publication date |
|---|---|---|---|---|---|
| US 5196745 | A | 23-03-1993 | NONE | | |
| US 6144118 | A | 07-11-2000 | DE | 19982072 T0 | 04-01-2001 |
| | | | EP | 1055163 A1 | 29-11-2000 |
| | | | JP | 2002525858 T | 13-08-2002 |
| | | | TW | 449680 B | 11-08-2001 |
| | | | WO | 0017724 A1 | 30-03-2000 |
| EP 0502578 | A | 09-09-1992 | NL | 9100407 A | 01-10-1992 |
| | | | DE | 69221915 D1 | 09-10-1997 |
| | | | DE | 69221915 T2 | 05-03-1998 |
| | | | EP | 0502578 A1 | 09-09-1992 |
| | | | JP | 5121294 A | 18-05-1993 |
| | | | JP | 2002319535 A | 31-10-2002 |
| | | | KR | 249379 B1 | 01-06-2000 |
| | | | US | 5172160 A | 15-12-1992 |
| EP 1001512 | A | 17-05-2000 | EP | 1001512 A2 | 17-05-2000 |
| | | | JP | 2000201471 A | 18-07-2000 |
| | | | KR | 2000047607 A | 25-07-2000 |
| US 6028376 | A | 22-02-2000 | JP | 11243132 A | 07-09-1999 |
| US 6147421 | A | 14-11-2000 | NONE | | |
| US 6208045 | B1 | 27-03-2001 | NONE | | |
| US 2002000904 | A1 | 03-01-2002 | WO | 0191204 A2 | 29-11-2001 |
| | | | EP | 1292968 A2 | 19-03-2003 |
| | | | TW | 498368 B | 11-08-2002 |
| DE 3123759 | A | 15-07-1982 | DE | 3123759 A1 | 15-07-1982 |
| | | | JP | 57080258 A | 19-05-1982 |

EPO FORM P0459

For more details about this annex : see Official Journal of the European Patent Office, No. 12/82

25